# EUROPEAN PATENT APPLICATION

(11) **EP 4 485 619 A1**
(43) Date of publication of application: **01.01.2025**
(21) Application number: 23879058.8
(22) Date of filing: 16.10.2023
(51) Int. Cl.: H01M 10/48, H01M 10/613

(54) **BATTERY PACK, ELECTRIC APPARATUS, BATTERY PACK TEST METHOD AND COMPUTER STORAGE MEDIUM**

(30) Priority: 21.10.2022 CN 202211292957
(71) Applicant: Contemporary Amperex Technology (Hong Kong) Limited, Central, Central And Western District (HK)
(72) Inventor: ZHU, Cuicui, Ningde, Fujian 352100 (CN); ZHANG, Jijun, Ningde, Fujian 352100 (CN); WANG, Shaofei, Ningde, Fujian 352100 (CN); WEI, Yimin, Ningde, Fujian 352100 (CN)
(74) Representative: von Tietzen und Hennig, Nikolaus
(86) International application number: PCT/CN2023/124707
(87) International publication number: WO 2024/083069

(57) **Abstract**

This application provides a battery pack, an electric apparatus, a detection method of a battery pack, and a computer storage medium, where the battery pack includes: a cell module, including at least one cell; a first collection module, including at least one first collection unit, the first collection unit being disposed within the cell, the first collection unit being configured to collect first operational data of the cell; a data processing module, connected to the first collection unit, configured to perform thermal runaway detection on the cell based on the first operational data to obtain a first detection result; a second collection module, disposed outside the cell module, configured to be activated when the first detection result indicates that any one of the cell has a thermal runaway risk, and collect second operational data of the cell after activation; the data processing module is further connected to the second collection module, and further configured to perform secondary detection based on the second operational data to determine whether the cell has a thermal runaway risk, so as to obtain a second detection result.

## Description

### CROSS-REFERENCE TO RELATED APPLICATIONS

This application claims priority to Chinese Patent Application No. 202211292957.9 entitled "BATTERY PACK, ELECTRIC APPARATUS, DETECTION METHOD OF BATTERY PACK, AND COMPUTER STORAGE MEDIUM" filed on October 21, 2022, which is incorporated herein by reference in its entirety.

### TECHNICAL FIELD

This application relates to the field of new energy technologies, and in particular, to a battery pack, an electric apparatus, a detection method of a battery pack, and a computer storage medium.

### BACKGROUND

With the development of new energy technology, application of batteries is becoming more and more widespread. However, under the influence of various factors, batteries may experience thermal runaway, which will release a large amount of heat and harmful gases, causing batteries to catch fire or even explode.

### SUMMARY

Embodiments of this application provide a battery pack, an electric apparatus, a detection method of a battery pack, and a computer storage medium, to provide a thermal runaway detection solution, thereby helping to improve the safety of electric apparatuses and people, while addressing the issues of high thermal runaway detection errors and short service life of temperature sensors in related arts.

According to an aspect, this application provides a battery pack which may include:
a cell module, which may include at least one cell;
a first collection module, which may include at least one first collection unit, where the first collection unit is disposed within the cell, and the first collection unit is configured to collect first operational data of the cell;
a data processing module, connected to the first collection unit, and configured to perform thermal runaway detection on the cell based on the first operational data to obtain a first detection result; and
a second collection module, disposed outside the cell module, and configured to be activated when the first detection result indicates that any one of the cell has a thermal runaway risk, and collect second operational data of the cell after activation; where
the data processing module is further connected to the second collection module, and further configured to perform secondary detection based on the second operational data to determine whether the cell has a thermal runaway risk, so as to obtain a second detection result.

In these embodiments, the cell module, the first collection module, the second collection module, and the data processing module are disposed. The first collection module may include the at least one first collection unit, and the data processing module is connected to the first collection unit, and configured to perform thermal runaway detection on the cell based on the first operational data to obtain the first detection result. The second collection module is connected to the data processing module, and can be activated when the first detection result indicates that any one of the cell has a thermal runaway risk, and collect the second operational data of the cell after activation. The data processing module can further perform secondary detection based on the second operational data to determine whether the cell has a thermal runaway risk, so as to obtain the second detection result. The first collection unit is disposed within the cell, achieving direct collection of internal operational data of the cell, and more accurately reflecting the internal operation condition of the cell. In addition, the second collection module outside the cell module is activated after presence of a thermal runaway risk is determined based on the internal operational data of the cell, and secondary detection is performed based on the second operational data collected by the second collection module, so that the accuracy of thermal runaway warning detection can be improved through secondary detection by using internal and external data. In addition, the second collection module is activated only when the first detection result indicates the presence of a thermal runaway risk, and the second collection module intermittently collects the second operational data, thus extending the service life of the second collection module.

Optionally, the battery pack may further include:
a thermal management module, connected to the data processing module, and configured to balance temperature of the cell when the first detection result indicates that any one of the cell has a thermal runaway risk.

In these embodiments, the thermal management module balances the temperature of the cell after a level-1 warning is generated (that is, after the first detection result indicates that any one of the cell has a thermal runaway risk), a temperature reduction operation can be performed on the cell in advance as compared with related arts, helping to reduce the thermal runaway risk of the cell and improve the safety of the cell.

Optionally, the first collection unit may include:
the first temperature collection unit is configured to collect first temperature data of the cell, and the first operational data may include the first temperature data; and
the data processing module is configured to perform thermal runaway detection on the cell based on the first temperature data, and when the first temperature data meets a temperature runaway condition, indicate the first detection result as the cell having a thermal runaway risk.

In these embodiments, an optional thermal runaway warning solution of disposing the first temperature collection unit in the cell is provided, helping to offer a highly accurate and sensitive thermal runaway detection solution, and enabling early implementation of battery thermal runaway management to a maximum extent. This improves the accuracy of thermal runaway warning, and earns more time for subsequent thermal management and thermal runaway warning notification, thereby addressing the issue of severe lag in thermal runaway warning in related arts.

Optionally, the first collection unit may further include a primary collection unit; where
the primary collection unit is configured to collect third operational data of the cell other than the first temperature data, and the first operational data may include the third operational data; and
the data processing module is configured to perform thermal runaway detection on the cell based on the first temperature data when the third operational data meets a data detection condition of a corresponding type.

In these embodiments, before thermal runaway detection is performed on the cell based on the first temperature data, the data detection condition determining of the third operational data can be added to exclude possible abnormalities of the first temperature collection unit, improving the accuracy of thermal runaway detection of the cell, and providing a reference for identifying the root cause of thermal runaway of the cell.

Optionally, the cell may include a housing and electrode plates accommodated in the housing, and the primary collection unit may include:
a pressure collection unit, where the pressure collection unit corresponds to the first temperature collection unit, the pressure collection unit is attached to an inner surface of the housing and/or the electrode plate, the pressure collection unit is configured to collect pressure data of the cell, and the third operational data may include the pressure data;
where when the pressure data is greater than a pressure threshold, the third operational data meets the data detection condition of a corresponding type.

In these embodiments, considering that the internal pressure of the cell being too high causes the internal temperature of the cell to rise, thus imposing a thermal runaway risk, a level-1 warning of local force-induced thermal runaway can be implemented by using a combination of the built-in pressure collection unit and the first temperature collection unit. With thermal runaway risk assessment performed, the root cause of the internal thermal runaway of the cell is identified, providing a reference for subsequent thermal runaway analysis and detection.

Optionally, the data processing module is further configured to: when the pressure data is greater than the pressure threshold and the first temperature data does not meet the temperature runaway condition, indicate the first detection result as the cell having a force abnormality.

In these embodiments, the data processing module analyzes the case of excessively high pressure of the cell to determine whether it is a local force abnormality or thermal runaway caused by a local force abnormality, achieving accurate abnormality analysis of excessively large internal pressure of the cell.

Optionally, the cell may include a jelly roll, a housing, and a top cover, the jelly roll being accommodated in an accommodation space enclosed by the housing and the top cover, and the primary collection unit may include:
an internal gas pressure and gas collection unit, disposed between the top cover and the jelly roll, and configured to collect gas pressure data inside the housing and concentration of at least one type of gas;
where when the gas pressure data is greater than a gas pressure threshold and gas concentration of any type is greater than a concentration threshold of a corresponding type, the third operational data meets the data detection condition of a corresponding type.

In these embodiments, disposing the internal gas pressure and gas collection unit inside the cell can effectively check whether a large amount of gas is generated inside the cell, so that thermal runaway of the cell caused by a gas generation abnormality can be accurately determined with reference to the change in the first temperature data.

Optionally, the data processing module is further configured to: when the gas pressure data is greater than the gas pressure threshold, the first temperature data does not meet the temperature runaway condition, and the gas concentration of any type is greater than the concentration threshold of a corresponding type, indicate the first detection result as the cell having a gas generation abnormality.

In these embodiments, whether it is thermal runaway caused by gas generation or a gas generation abnormality can be determined, achieving accurate abnormality analysis of internal gas generation of the cell, thereby identifying the root cause of thermal runaway, and providing a favorable reference for subsequent thermal runaway detection and analysis of the cell.

Optionally, the battery pack may further include:
a third collection module, configured to collect electrical data corresponding to the cell, where the electrical data may include at least one of a voltage value and current value of a loop in which the cell is located, and an insulation resistance value of the cell;
where when the insulation resistance value is less than a resistance threshold, the current value is greater than a current threshold, or a decrease speed of the voltage value is greater than a speed threshold, the third operational data meets the data detection condition of a corresponding type.

In these embodiments, the thermal runaway risk caused by electrical reasons of the cell is considered to explore the root cause of internal thermal runaway of the cell and provide a reference for subsequent thermal runaway analysis and detection.

Optionally, the data processing module is further configured to: when it is determined, based on the electrical data, that the third operational data meets the data detection condition of a corresponding type and the first temperature data does not meet the temperature runaway condition, indicate the first detection result as the cell having a short-circuit abnormality.

In these embodiments, after the electrical data is determined, determining whether the first temperature data meets the temperature runaway condition can determine whether the short-circuit abnormality of the cell leads to the thermal runaway risk of the cell, achieving accurate short-circuit abnormality analysis of the cell. In addition, the electrical data, gas generation, and the internal pressure of the cell form a level-1 signal collection system, thereby triggering the determining of whether the first temperature data meets the temperature runaway condition. This is based on various root causes of thermal runaway, comprehensively identifying inducements of thermal runaway while achieving thermal runaway risk warning.

Optionally, the second collection module may include:
a second temperature collection unit, configured to be activated when the first detection result indicates that any one of the cell has a thermal runaway risk, and collect second temperature data of the cell after activation, where the second operational data may include the second temperature data; where
the data processing module is further configured to: when the second temperature data is greater than an external temperature threshold, indicate the second detection result as the cell having a level-2 thermal runaway risk.

In these embodiments, disposing the second temperature collection unit provides an optional implementation manner for the data processing module to perform secondary detection of thermal runaway risk based on the second operational data. A risk signal indicating spread-out of internal thermal runaway of the cell can be captured, so that the extent of the spread-out of internal thermal runaway of the cell can be learned in time. Second, an external signal change caused by a change in external condition such as high temperature can be reflected, implementing thermal runaway risk warning caused by external factors. In addition, the second temperature collection unit is activated only when the first detection result indicates that any one of the cell has a thermal runaway risk, and therefore the non-continuous working state of the second temperature collection unit can avoid vain work, greatly improving the actual service life of the second temperature collection unit.

Optionally, the second collection module may further include:
an external gas pressure and gas collection unit, configured to be activated when the first detection result indicates that any one of the cell has a thermal runaway risk, and collect external gas pressure data and concentration of at least one type of external gas of the cell module after activation; where
the data processing module is further configured to: when the external gas pressure data is greater than an external gas pressure threshold, the concentration of at least one type of external gas is greater than a concentration threshold of a corresponding type, and the second temperature data is less than or equal to the external temperature threshold, indicate the second detection result as a level-2 gas generation abnormality warning.

In these embodiments, the abnormality cause and danger level of the battery pack can be learned in time, and measures can be correspondingly taken. In addition, disposing both the internal and external gas and gas pressure collection units and the temperature collection units, the accuracy of identifying thermal runaway and gas generation abnormality of the battery pack can be improved, preventing erroneous determining.

Optionally, the second collection module may include:
a smoke concentration collection unit, configured to be activated when the first detection result indicates that any one of the cell has a thermal runaway risk, and collect smoke concentration outside the cell module after activation, where the second operational data may include the smoke concentration;
where when the smoke concentration is greater than a smoke concentration warning value, the second detection result indicates that the cell has a level-2 thermal runaway risk.

In this embodiment, disposing the smoke concentration collection unit provides an optional implementation manner for the data processing module to perform secondary detection of thermal runaway risk based on the second operational data. A risk signal indicating spread-out of internal thermal runaway of the cell can be captured, so that the extent of the spread-out of internal thermal runaway of the cell can be learned in time. Second, an external signal change caused by a change in external condition such as high temperature or high pressure can be reflected, implementing thermal runaway risk warning caused by external factors. Smoking of the battery pack can further be identified, reminding people around to take timely measures.

In addition, the smoke concentration collection unit can be combined with the second temperature collection unit, so that the presence of a level-2 thermal runaway risk of the cell can be determined based on the data collected by either unit, improving the accuracy of external thermal runaway risk detection. In addition, the smoke concentration collection unit is activated only when the first detection result indicates that any one of the cell has a thermal runaway risk, and therefore the non-continuous working state of the smoke concentration collection unit can avoid vain work, greatly improving the actual service life of the smoke concentration collection unit.

According to another aspect, this application further provides an electric apparatus, and the electric apparatus may include the battery pack in the foregoing aspect.

According to yet another aspect, this application provides a detection method of a battery pack, applied to a data processing module. The battery pack may include a cell module, a first collection module, and a second collection module disposed outside the cell module, the cell module may include at least one cell, the first collection module may include at least one first collection unit, the first collection unit is disposed within the cell, and the method may include:
obtaining first operational data of the cell collected by the first collection module;
performing thermal runaway detection on the cell based on the first operational data to obtain a first detection result;
when the first detection result indicates that any one of the cell has a thermal runaway risk, controlling the second collection module to be activated and obtaining external second operational data of the cell collected by the second collection module; and
performing secondary detection based on the second operational data to determine whether the cell has a thermal runaway risk, so as to obtain a second detection result.

According to another aspect, this application further provides a computer storage medium. The computer storage medium stores a program or an instruction. When the program or the instruction is executed by a processor, the steps of the detection method of the battery pack in the foregoing aspect are implemented.

According to another aspect, this application further provides a computer storage medium. When the computer storage medium is executed by a processor, the steps of the detection method of the battery pack in the foregoing aspect are implemented.

According to another aspect, this application further provides a computer program product. The computer program product can be executed by a processor to implement the steps of the detection method of the battery pack in the foregoing aspect.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings described below show merely some embodiments of this application, and persons of ordinary skill in the art may still derive other drawings from the accompanying drawings without creative efforts.
FIG. 1 is a schematic diagram of a module structure of an embodiment of a battery pack according to an embodiment of this application.
FIG. 2 is a schematic diagram of a module structure of another embodiment of a battery pack according to an embodiment of this application.
FIG. 3 is a schematic diagram of a module structure of still another embodiment of a battery pack according to an embodiment of this application.
FIG. 4 is a schematic diagram of a position of a temperature collection unit used in a battery pack according to an embodiment of this application.
FIG. 5 is another schematic diagram of a position of a temperature collection unit used in a battery pack according to an embodiment of this application.
FIG. 6 is a schematic diagram of a module structure of yet another embodiment of a battery pack according to an embodiment of this application.
FIG. 7 is a schematic diagram of a module structure of yet another embodiment of a battery pack according to an embodiment of this application.
FIG. 8 is a schematic diagram of a module structure of yet another embodiment of a battery pack according to an embodiment of this application.
FIG. 9 is a schematic diagram of a module structure of yet another embodiment of a battery pack according to an embodiment of this application.
FIG. 10 is an optional schematic flowchart of a detection method of a battery pack according to an embodiment of this application.

Reference signs are as follows:
100. battery pack;
110. cell module; 120. first collection module; 130. data processing module; 140. second collection module;
111. cell; 121. first collection unit; 141. second temperature collection unit; 142. external gas pressure and gas collection unit; 143. smoke concentration collection unit;
210. thermal management module;
310. temperature collection unit;
410. straight portion; 420. bent portion; X. first direction;
610. primary collection unit;
710. pressure collection unit;
810. internal gas pressure and gas collection unit; and
910. third collection module.

### DESCRIPTION OF EMBODIMENTS

The following describes in detail the embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by those skilled in the art to which this application relates. The terms used herein are intended to merely describe the specific embodiments rather than to limit this application. The terms "include", "include", and "have" and any other variations thereof in the specification, claims and brief description of drawings of this application are intended to cover non-exclusive inclusions.

In the description of the embodiments of this application, the terms "first", "second" and the like are merely intended to distinguish between different objects, and shall not be understood as any indication or implication of relative importance or any implicit indication of the number, sequence or primary-secondary relationship of the technical features indicated. In the description of the embodiments of this application, "a plurality of" means at least two unless otherwise specifically stated.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art that the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the description of the embodiments of this application, the term "a plurality of" means more than two (inclusive). Similarly, "a plurality of groups" means more than two (inclusive) groups, and "a plurality of pieces" means more than two (inclusive) pieces.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of description of the embodiments of this application rather than indicating or implying that the means or components mentioned must have specific orientations or must be constructed or manipulated according to specific orientations, and therefore shall not be construed as any limitations on embodiments of this application.

In the new energy field, a traction battery may be used as a major traction source for an electric device (such as a vehicle, a ship, or a spacecraft), and an energy storage battery may be a charging source for the electric device. The importance of the traction battery and the energy storage battery is taken for granted. As examples instead of limitations, in some application scenarios, the traction battery may be a battery in an electric device, and the energy storage battery may be a battery in a charging device. For ease of description, the traction battery and the energy storage battery may be collectively referred to as a battery below.

With the development of new energy technology, the demand for traction batteries and the energy density inside traction batteries are increasing in parallel. In a long time in the future, as the energy density of batteries continues to increase, the thermal runaway risk also shows an increase trend.

In related arts, early warning of battery thermal runaway is typically carried out by measuring early characteristic parameters of thermal runaway using temperature sensors arranged inside a battery pack, and then performing battery thermal runaway warning based on the characteristic parameters obtained from the measurements and evidence theory models. However, this solution has a high error rate in thermal runaway detection, and because the temperature sensors continuously measure the parameters, the service life of the temperature sensors is also relatively short.

To solve the above technical problems, this application provides a battery pack, an electric apparatus, a detection method of a battery pack, and a computer storage medium. The following first describes the battery pack provided in the embodiments of this application.

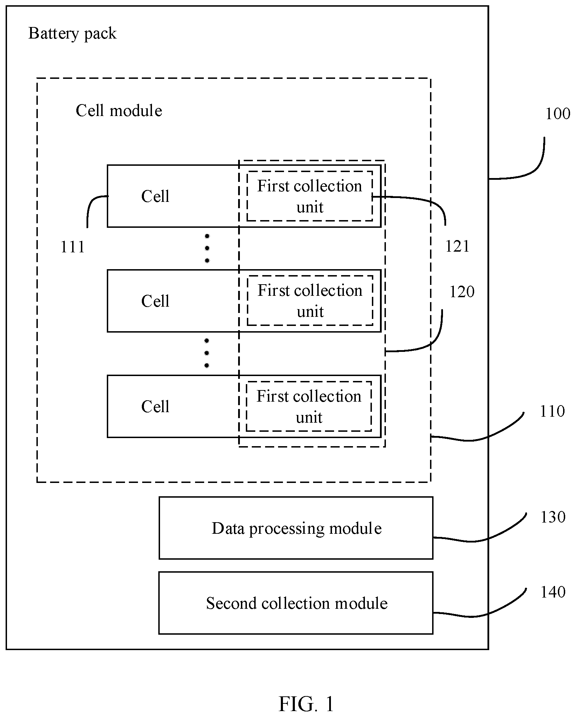

Referring to FIG. 1, FIG. 1 is a schematic diagram of a module structure of an optional embodiment of a battery pack 100 according to an embodiment of this application. In this embodiment, the battery pack 100 may include a cell module 110, a first collection module 120, a data processing module 130, and a second collection module 140.

The cell module 110 may include at least one cell 111.

The first collection module 120 may include at least one first collection unit 121, the first collection unit 121 may be disposed within the cell 111, and the first collection unit 121 may be configured to collect first operational data of the cell 111.

The data processing module 130 is connected to the first collection unit 121, and the data processing module 130 may be configured to perform thermal runaway detection on the cell 111 based on the first operational data to obtain a first detection result.

The second collection module 140 may be disposed outside the cell module 110. The second collection module 140 may be configured to be activated when the first detection result indicates that any one of the cell 111 has a thermal runaway risk, and collect second operational data of the cell 111 after activation.

The data processing module 130 may further be connected to the second collection module 140, and the data processing module 130 may further be configured to perform secondary detection based on the second operational data to determine whether the cell 111 has a thermal runaway risk, so as to obtain a second detection result.

In this embodiment of this application, the cell module 110, the first collection module 120, the second collection module 140, and the data processing module 130 are disposed. The first collection module 120 may include the at least one first collection unit 121, and the data processing module 130 may be connected to the first collection unit 121, and configured to perform, based on the first operational data, thermal runaway detection on the cell 111 included in the cell module 110 to obtain the first detection result. The second collection module 140 is connected to the data processing module 130, and can be activated when the first detection result indicates that any one of the cell 111 has a thermal runaway risk, and collect the second operational data of the cell 111 after activation. The data processing module 130 can further perform secondary detection based on the second operational data to determine whether the cell 111 has a thermal runaway risk, so as to obtain the second detection result. The first collection unit 121 is disposed within the cell 111, achieving direct collection of internal operational data of the cell 111, and more accurately reflecting the internal operation condition of the cell 111. In addition, the second collection module 140 outside the cell module 110 is activated after presence of a thermal runaway risk is determined based on the internal operational data of the cell 111, and secondary detection is performed based on the second operational data collected by the second collection module 140, so that the accuracy of thermal runaway warning detection can be improved through secondary detection by using internal and external data. In addition, the second collection module 140 is activated only when the first detection result indicates the presence of a thermal runaway risk and in an intermittent collection state, thus extending the service life of the second collection module 140.

The battery pack 100 may include the at least one cell 111 and the at least one first collection unit 121, the first collection unit 121 may correspond to the cell 111, and the first collection unit 121 may be disposed within the corresponding cell 111. The cell 111 may be a hard-shell cell, a pouch cell, a laminated cell, or a cylindrical cell.

Each first collection unit 121 may include a single or multiple collection elements, and all the collection elements are disposed within the cell 111. The collection elements may be sensors or other collection elements for obtaining the first operational data. For example, the first collection unit 121 may at least include a temperature collection unit, and in other examples, may further include a pressure collection unit, a gas collection unit, a gas pressure collection unit, and the like. These collection elements have strong corrosion resistance, making them suitable to be stably disposed inside the cell 111.

The data processing module 130 may be a BMS (Battery Management System, battery management system), or a chip dedicated to thermal runaway risk warning. The data processing module 130 and the first collection unit 121 may be electrically connected through a wire. For example, after the first collection unit 121 collects a signal, the first collection unit 121 may lead out the signal collected through its independent wire, and subsequently, the first operational data collected by the first collection unit 121 inside the cell 111 can be obtained through signal decoupling.

The first operational data is related to the type of the first collection unit 121. For example, when the first collection unit 121 includes a first temperature collection unit 310, the first operational data may include first temperature data collected by the first temperature collection unit 310. When the first collection unit 121 includes a gas collection unit, the first operational data may include a gas concentration collected by the gas collection unit.

When performing thermal runaway warning, the data processing module 130 may determine, based on the first operational data and different operation conditions of the first operational data, whether any one of the cell 111 in the battery pack 100 meets the thermal runaway detection condition. When any one of the cell 111 meets the thermal runaway detection condition, the first detection result may be indicated as the battery pack 100 and/or the cell 111 in the battery pack 100 that meets the thermal runaway detection condition having a thermal runaway risk. In this case, the data processing module 130 may issue a level-1 thermal runaway warning, and personnel can evacuate in time. Conversely, when no cell 111 meets the thermal runaway detection condition, the first detection result indicates that none of the battery pack 100 and all the cells 111 meets the thermal runaway detection condition. In this case, the data processing module 130 may trigger the first collection module 120 to continue signal collection.

The battery pack 100 may further include a second collection module 140. The second collection module 140 may be disposed outside the cell module 110. That is, the second collection module 140 may collect external operational data (that is, the second operational data) of the cell module 110 within the battery pack 100. The second collection module 140 may be activated when the first detection result indicates that the cell 111 or the battery pack 100 has a thermal runaway risk, and collect the external second operational data of the cell 111 after activation.

The second operational data mainly refers to environmental data of the cell 111 within the battery pack 100. The second operational data may be at least partially the same as the first operational data in type. For example, both the second operational data and the first operational data may include temperature data. In addition, the second operational data may further include the smoke concentration, gas pressure, and gas concentration, and the like within the battery pack 100.

After collecting the second operational data of the cell 111 within the battery pack 100, the second collection module 140 may send the second operational data to the data processing module 130 electrically connected to it. The data processing module 130 may perform secondary detection based on the second operational data to determine whether the cell 111/battery pack 100 has a thermal runaway risk, so as to obtain the second detection result.

When the data processing module 130 performs secondary detection and determines, based on the second detection result, that the cell 111/battery pack 100 has a thermal runaway risk, a level-2 thermal runaway warning may be initiated.

It should be noted that a level-1 signal collection mechanism inside the cell 111 and a corresponding thermal runaway warning solution can reflect internal problems of the cell 111 in time, so that the thermal runaway risk of the cell 111 can be responded to first. The secondary verification performed by the second collection module 140 can capture a risk signal indicating spread-out of internal thermal runaway of the cell 111, and also reflect an external signal change caused by a change in external conditions such as external mechanical squeezing and high temperature, implementing thermal runaway risk warning caused by external factors.

In these embodiments, the level-1 signal collection mechanism established by the first collection module 120 inside the cell 111, and the secondary verification of the second collection module 140 can allow the first operational data and the second operational data collected internally and externally to be mutually supplemented and verified. This improves the accuracy of detection and state determining of the internal and external parts of the cell 111 and the battery pack 100, thus overcoming the erroneous determining caused by using a single signal collection module for warning determining. In addition, the second collection module 140 is activated only when the first detection result indicates that the cell 111/battery pack 100 has a thermal runaway risk. This non-continuous working state can avoid vain work, greatly improving the actual service life of the second collection module 140.

In some embodiments, when secondary detection of thermal runaway risk is performed based on the second operational data, if the detection result is normal, the secondary detection can be continued until the level-1 thermal runaway warning is lifted. It should be noted that when the level-1 warning appears, it indicates that a thermal runaway risk is present inside the cell 111, but it may not have spread out the cell 111. In this case, the thermal runaway risk can be eliminated through cooling measures such as thermal management until all the first operational data inside the cell 111 returns to normal, at which point the level-1 warning can be lifted, and the secondary detection can be stopped. This allows for continuous detection of whether the thermal runaway risk inside the cell 111 has spread out, ensuring the safety of the environment in which the battery pack 100 is located.

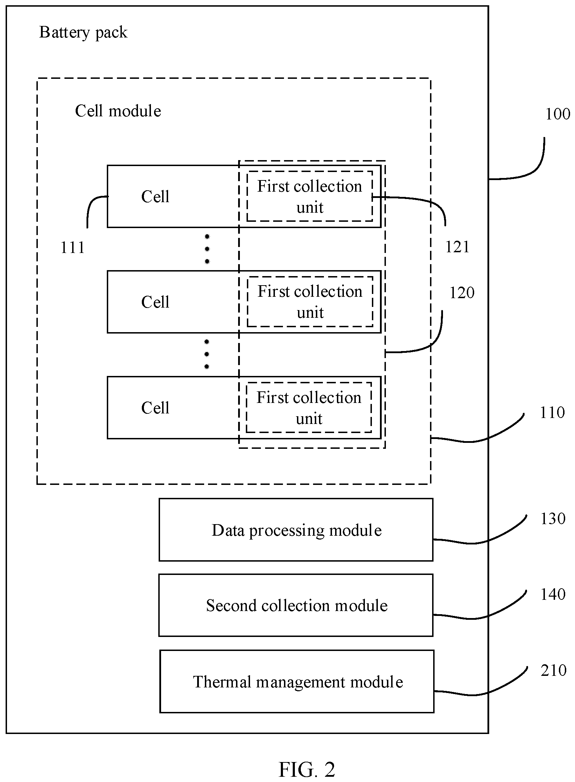

Referring to FIG. 2, based on the above embodiments, another embodiment of this application is proposed. In this embodiment, the battery pack 100 may further include a thermal management module 210. The thermal management module 210 may be connected to the data processing module 130. The thermal management module 210 may balance the temperature of the cell 111 when the first detection result indicates that any one of the cell 111 has a thermal runaway risk.

When the first detection result indicates that any one of the cell 111 has a thermal runaway risk, the thermal management module 210 can be adjusted to achieve temperature control, thereby reducing the internal temperature of the cell 111. In addition, the first collection module 120 inside the cell 111 can continue to collect the first operational data to determine whether the cooling solution of the thermal management module 210 can lift the level-1 warning.

The measures taken by the thermal management module 210 for balancing the temperature of the cell 111 can be designed with reference to the related arts before the application date of this case, depending on an actual need. Details are not described herein. These embodiments of this application mainly focus on the timing of the thermal management module 210 in balancing the temperature of the cell 111.

In these embodiments, the thermal management module 210 balances the temperature of the cell 111 after a level-1 warning is generated (that is, after the first detection result indicates that any one of the cell 111 has a thermal runaway risk), a temperature reduction operation can be performed on the cell 111 in advance as compared with related arts, helping to reduce the thermal runaway risk of the cell 111 and improve the safety of the cell 111.

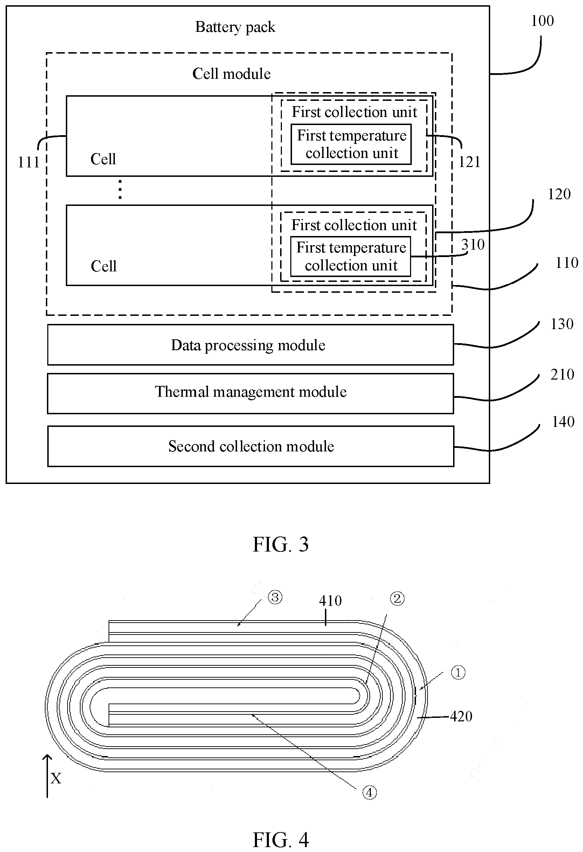

Referring to FIG. 3, based on the above embodiments, another embodiment of this application is proposed. In this embodiment, the first collection unit 121 may include a first temperature collection unit 310.

The first temperature collection unit 310 may be configured to collect first temperature data of the cell 111, and the first operational data may include the first temperature data.

The data processing module 130 may obtain the first temperature data collected by the first temperature collection unit 310 through an electrically connected wire. Then, the data processing module 130 may perform thermal runaway detection on the cell 111 based on the first temperature data. When the first temperature data meets the temperature runaway condition, the data processing module 130 may indicate the first detection result as the cell 111 having a thermal runaway risk, and in this case, initiate a level-1 thermal runaway warning.

The first temperature collection unit 310 may be a temperature sensor or another temperature collection device for temperature collection. The type of the temperature sensor may include one or more of optical fiber sensors, bimetal thermometers, glass liquid thermometers, pressure thermometers, resistance thermometers, thermistors, and thermocouples. The first temperature collection unit 310 may be attached to an electrode plate in a form of array, and its attachment position may be set depending on actual needs.

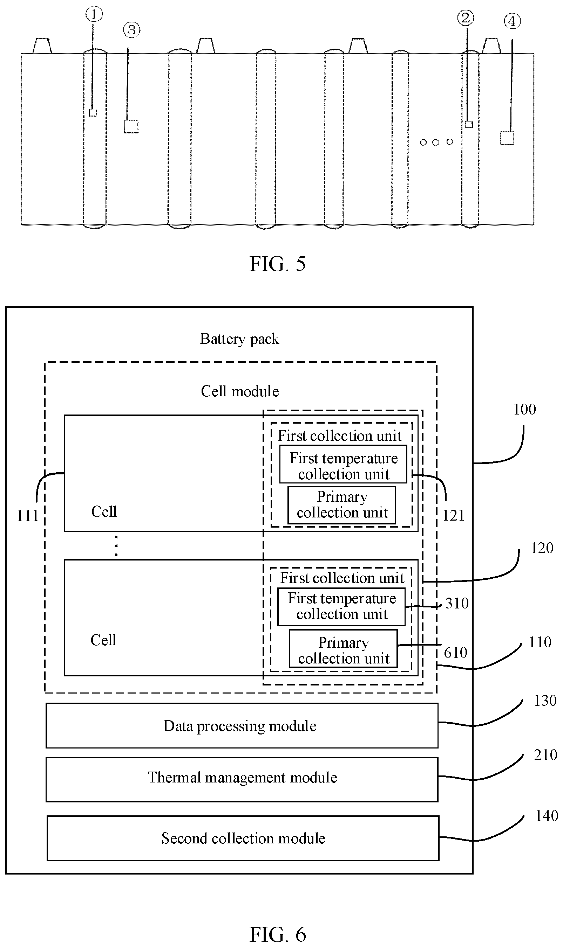

It should be noted that the cell 111 may include a jelly roll, and the jelly roll is accommodated in an accommodation space formed by a top cover and a housing. The jelly roll may be formed by winding a separator and electrode plates. For example, refer to FIGs. 3 to 5 together. FIGs. 4 and 5 are schematic diagrams of optional distribution positions of the first temperature collection unit 310 when the electrode plates inside the cell 111 are a wound structure (that is, positions marked by ① to ④ in the figures). The electrode plate may be an anode electrode plate, and the electrode plate can be wound around a winding axis to form a wound structure. The electrode plate may include multiple straight portions 410 and multiple bent portions 420. The multiple straight portions 410 may be stacked along a first direction X, and the multiple bent portions 420 may be at least partially bent in an arc shape and connect two adjacent straight portions 410. The first direction X is perpendicular to the winding axis. The first temperature collection unit 310 may be attached to the straight portion 410 and/or the bent portion 420.

The first temperature collection unit 310 may be attached to the bent portion 420 of the outermost/innermost electrode plate inside the cell 111, or may be attached to the straight portion 410 of the outermost/innermost electrode plate inside the cell 111. Certainly, the first temperature collection unit 310 may alternatively be attached to the middle electrode plate.

The first temperature data meeting the temperature runaway condition may mean that the first temperature data exceeds a temperature threshold. That is, when the first temperature data exceeds the temperature threshold, the first detection result indicates that the cell 111 has a thermal runaway risk. Conversely, if the first temperature data does not exceed the temperature threshold, the first detection result indicates that the cell 111 temporarily does not have a thermal runaway risk.

It should also be noted that when the first temperature collection unit 310 is disposed at multiple positions, temperature thresholds of the corresponding positions may be different. This has the temperature differences at various positions inside the cell 111 taken into account.

In these embodiments, an optional thermal runaway warning solution of disposing the first temperature collection unit 310 in the cell 111 is provided, helping to offer a highly accurate and sensitive thermal runaway detection solution, and enabling early implementation of battery thermal runaway management to a maximum extent. This improves the accuracy of thermal runaway warning, and earns more time for subsequent thermal management and thermal runaway warning notification, thereby addressing the issue of severe lag in thermal runaway warning in related arts.

Referring to FIG. 6, based on the above embodiments, yet another embodiment of this application is proposed. In this embodiment, in addition to the first temperature collection unit 310, the first collection unit 121 may further include a primary collection unit 610.

The primary collection unit 610 may be configured to collect third operational data of the cell 111 other than the first temperature data, and the first operational data may correspondingly further include the third operational data.

After the primary collection unit 610 collects the third operational data of the cell 111, the data processing module 130 may obtain, through a wire, the third operational data collected by the primary collection unit 610, and then perform thermal runaway detection on the cell 111 based on the first temperature data when the third operational data meets the data detection condition of a corresponding type.

The main difference between this embodiment and the previous embodiments is the addition of the primary collection unit 610 and the data detection conditions corresponding to different data types. The added primary collection unit 610 can be disposed based on the inducements or principles of different thermal runaway phenomena occurring inside the cell 111.

For example, if the thermal runaway risk may be caused by an excessively high concentration of gas generated inside the cell 111, the primary collection unit 610 can perform gas and gas pressure concentration detection, thereby obtaining the third operational data. This allows the data processing module 130 to determine whether the third operational data meets a data detection condition of the gas and gas pressure concentration type.

The data detection condition is a condition for the third operational data to meet an abnormal phenomenon related to thermal runaway. When the third operational data meets the data detection condition of a corresponding type, thermal runaway detection may be performed on the cell 111 based on the first temperature data collected by the first temperature collection unit 310.

In these embodiments, before thermal runaway detection is performed on the cell 111 based on the first temperature data, the data detection condition determining of the third operational data can be added to exclude possible abnormalities of the first temperature collection unit 310, improving the accuracy of thermal runaway detection of the cell 111, and providing a reference for identifying the root cause of thermal runaway of the cell 111.

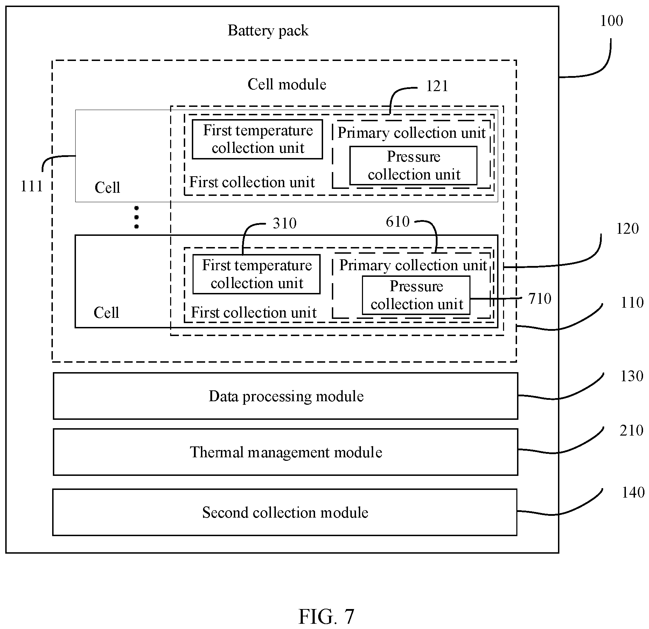

Referring to FIG. 7 and also referring to FIGs. 4 and 5 together, based on the above embodiments, yet another embodiment of the battery pack 100 of this application is proposed. In this embodiment, the primary collection unit 610 may include a pressure collection unit 710.

The pressure collection unit 710 may correspond to the first temperature collection unit 310. The pressure collection unit 710 may be attached to the straight portions 410 and/or the bent portions 420 shown in FIGs. 4 and 5, or may be attached to the inner surface of the housing. The pressure collection unit 710 may collect pressure data of the cell 111, and the third operational data includes the pressure data. When the pressure data is greater than a pressure threshold, the third operational data meets the data detection condition of a pressure type.

The pressure collection unit 710 may be a pressure sensor or another collection device for obtaining pressure data, where the types of pressure sensors may be at least one of strain gauge resistive type, electromagnetic type, capacitive type, piezoelectric type, electrostatic capacity type, and vibrating wire type.

The thickness of the pressure collection unit 710 is usually less than 10 µm. These pressure collection units 710 can be fixed on the electrode plate by packaging glue. In some embodiments, when the pressure collection unit 710 is attached to the straight portion 410, its effective area may be within the range of 1 cm*1 cm. When the pressure collection unit 710 is attached to the bent portion 420, the effective area of the pressure collection unit 710 may be within the range of 0.5 cm*0.5 cm.

In some examples, the pressure collection unit 710 may be disposed beside the first temperature collection unit 310. Before the cell 111 leaves the factory, the first temperature collection unit 310 and the pressure collection unit 710 can be uniformly packaged with battery glue to form a temperature-pressure collection array. This array can be in a form of thin film, having good flexibility, thereby making it suitable to be disposed at different positions inside the cell 111.

Still referring to FIG. 7 and also referring to FIG. 4, the pressure collection unit 710 can be disposed on the straight portion 410 and/or the bent portion 420 of the innermost/outermost electrode plate of the cell 111, or the pressure collection unit 710 may be disposed at certain positions on the inner surface of the housing of the cell 111. In other examples, the pressure collection unit 710 may alternatively be disposed on the middle electrode plate.

The straight portion 410 of the innermost electrode plate of the cell 111, the bent portion 420 of the outermost electrode plate of the cell 111, and the inner surface of the housing of the cell 111 each being provided with the pressure collection unit 710 is used as an example. Pressure data measured at the straight portion 410 of the innermost electrode plate of the cell 111 is first pressure data P1, pressure data measured at the bent portion 420 of the outermost electrode plate of the cell 111 is second pressure data P2, and pressure data measured at the inner surface of the housing of the cell 111 is third pressure data P3.

When any of the first pressure data P1 to the third pressure data P3 is greater than a corresponding pressure threshold, it can be considered that the third operational data meets the data detection condition of the corresponding pressure data type, and it can be determined whether the first temperature data meets the temperature runaway condition.

When none of the first pressure data P1 to the third pressure data P3 is greater than the corresponding pressure threshold, the pressure collection unit 710 can continue the detection.

In these embodiments, considering that the internal pressure of the cell 111 being too high causes the internal temperature of the cell 111 to rise, thus imposing a thermal runaway risk, a level-1 warning of local force-induced thermal runaway can be implemented by using a combination of the built-in pressure collection unit 710 and the first temperature collection unit 310. With thermal runaway risk assessment performed, the root cause of the internal thermal runaway of the cell 111 is identified, providing a reference for subsequent thermal runaway analysis and detection.

Still referring to FIG. 7, based on the above embodiments, yet another embodiment of the battery pack 100 of this application is proposed. In this embodiment, the data processing module 130 may alternatively be configured to: when the pressure data is greater than the pressure threshold and the first temperature data does not meet the temperature runaway condition, indicate the first detection result as the cell 111 having a force abnormality.

It should be noted that when pressure data at a certain position inside the cell 111 is greater than a pressure threshold at the corresponding position, it indicates that a local force abnormality has occurred inside the cell 111. However, this force abnormality has not caused the internal temperature of the cell 111 to rise, so there is no thermal runaway risk caused by this abnormality. The data processing module 130 can determine the first detection result as the cell 111 having a local force abnormality and issue a level-1 alarm for the local force abnormality.

In these embodiments, the data processing module 130 analyzes the case of excessively high pressure of the cell 111 to determine whether it is a local force abnormality or thermal runaway caused by a local force abnormality, achieving accurate abnormality analysis of excessively large internal pressure of the cell 111.

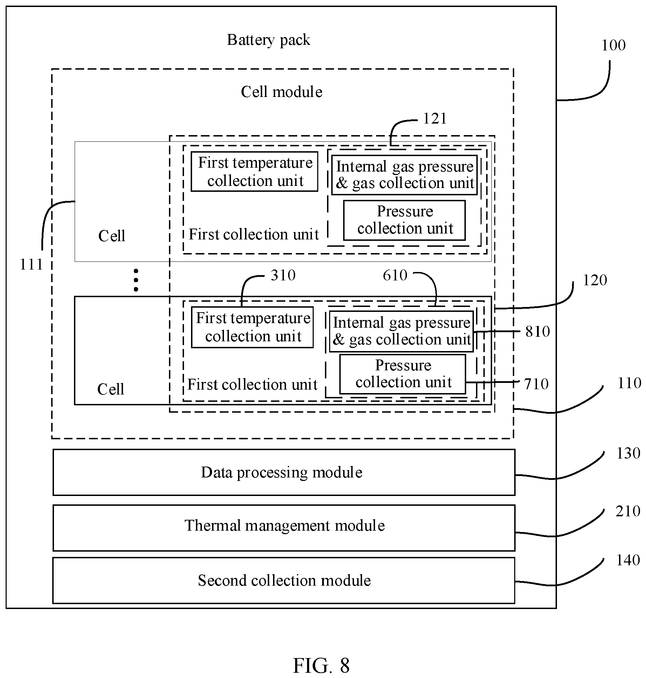

Referring to FIG. 8, based on the above embodiments, yet another embodiment of the battery pack 100 of this application is proposed. In this embodiment, the primary collection unit 610 may include an internal gas pressure and gas collection unit 810.

The internal gas pressure and gas collection unit 810 may be disposed between the top cover and the jelly roll, and the internal gas pressure and gas collection unit 810 may collect gas pressure data and concentration of at least one type of gas inside the housing. When the gas pressure data is greater than a gas pressure threshold and gas concentration of any type is greater than a concentration threshold of a corresponding type, it is determined that the third operational data meets the data detection condition of a corresponding type.

It should be noted that when the internal temperature of the cell 111 rises, the electrolyte and active materials will rapidly undergo side reactions, generating a large amount of explosive gases (such as hydrogen, carbon monoxide), volatile organic compounds (Volatile Organic Compounds, VOC), and carbon dioxide. In this case, the gas pressure will also rapidly increase, which can easily cause thermal runaway. Disposing the internal gas pressure and gas collection unit 810 inside the cell 111 can effectively check whether a large amount of gas is generated inside the cell 111, so that thermal runaway of the cell 111 caused by a gas generation abnormality can be accurately determined with reference to the change in the first temperature data.

The internal gas pressure and gas collection unit 810 can include a gas collection unit and a gas pressure collection unit. The gas collection unit may include various semiconductor gas sensors sensitive to gas, or the gas collection unit may be a gas sensor array made by integrating semiconductor gas sensors. The gas pressure collection unit can be a gas pressure sensor or the like. The type of gas pressure sensor can include one or more of strain gauge resistive type, electromagnetic type, capacitive type, piezoelectric type, electrostatic capacity type, and vibrating wire type.

The types of the gas sensors may include various types. After sensors are integrated into a gas sensor array, various different component concentrations can be detected while space is saved. The gas sensor can be configured to detect gases such as hydrogen, carbon monoxide, and carbon dioxide that cause gas generation failure in the cell 111, or may be configured to detect volatile organic compounds that are greatly affected by temperature. For example, the volatile organic compounds may include methane, ethylene, or the like.

For example, the gas collection unit can detect the gas concentrations of hydrogen, carbon monoxide, carbon dioxide, and VOC inside the cell 111, while the gas pressure collection unit can collect the gas pressure inside the cell 111. When the total gas pressure inside the cell 111 is not greater than the gas pressure threshold, or all types of gas concentrations are less than or equal to the gas concentration threshold of a corresponding type, gas generation inside the cell 111 is normal, and the detection of gas pressure and gas concentration can continue.

When the total gas pressure inside the cell 111 is greater than the gas pressure threshold, and the gas concentration of any type is greater than the gas concentration threshold of a corresponding type, it is determined that there is a gas generation abnormality inside the cell 111. It can be further checked whether the first temperature data is greater than the temperature threshold. When the first temperature data is greater than the temperature threshold, it is determined that there is a thermal runaway risk inside the cell 111 due to gas generation abnormality. Conversely, it is determined that there is a gas generation abnormality inside the cell 111, and a level-1 alarm for gas generation abnormality inside the cell 111 can be issued.

It should also be noted that the gas concentration thresholds of various types mentioned above can be set based on the actual impact of the gas concentration on thermal runaway. The gas concentration thresholds of various types can be the same or different.

In some other embodiments, the pressure of each type of gas can also be obtained by using the gas concentration and the total gas pressure: Pi=P*yi, where P is the gas pressure inside the cell 111, and y is gas concentration of type i. The pressure threshold corresponding to each type of gas is further used to determine whether there is a gas generation abnormality inside the cell 111.

Still referring to FIG. 8, based on the above embodiments, yet another embodiment of the battery pack 100 of this application is proposed. In this embodiment, the data processing module 130 is further configured to: when the gas pressure data is greater than the gas pressure threshold, the first temperature data does not meet the temperature runaway condition, and the gas concentration of any type is greater than the concentration threshold of a corresponding type, indicate the first detection result as the cell 111 having a gas generation abnormality.

If the first temperature data does not meet the temperature runaway condition, it indicates that the internal condition of the cell 111 has not met the thermal runaway risk warning condition caused by gas generation abnormality, but a gas generation abnormality has occurred. Therefore, whether it is thermal runaway caused by gas generation or a gas generation abnormality can be determined, achieving accurate abnormality analysis of internal gas generation of the cell 111, thereby identifying the root cause of thermal runaway, and providing a favorable reference for subsequent thermal runaway detection and analysis of the cell 111.

It should be noted that related arts have flammable gas detection schemes. In such flammable gas detection, gas that has spread out into the battery pack 100 is detected. This gas spreads out actually because gas inside the cell 111 is accumulated to a certain amount, making the gas pressure reach a limit to burst through an explosion-proof valve. Therefore, related arts have the risk of a lag in detection and warning, reducing the time for personnel to escape and respond. Furthermore, flammable gas detection mainly detects VOC gases. Therefore, as compared with related arts, in these embodiments, disposing the internal gas pressure and gas collection unit 810 inside the cell 111 and detecting gas concentrations of various types such as carbon monoxide, carbon dioxide, and methane, the thermal runaway warning scheme can have higher reliability, expand the scope of thermal runaway risk warning, and help reduce errors.

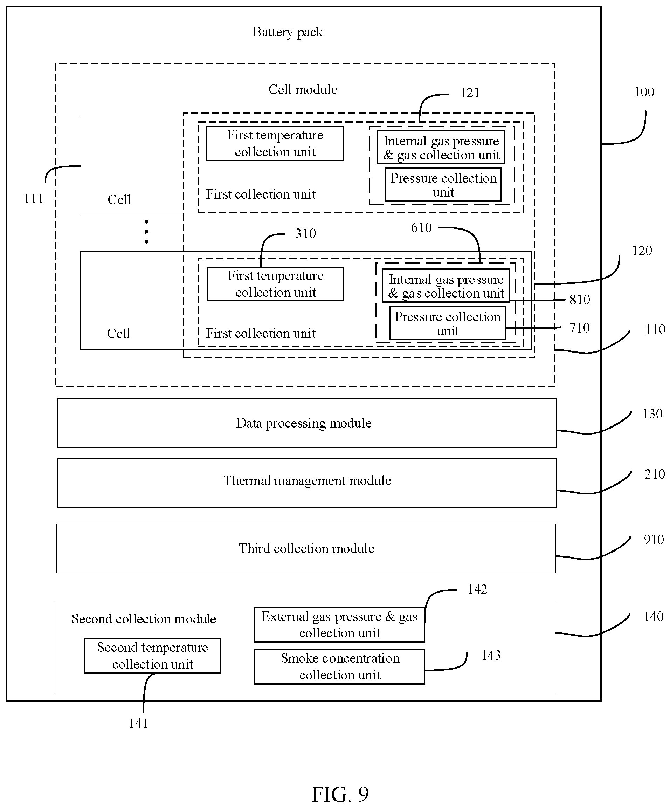

Referring to FIG. 9, based on the above embodiments, yet another embodiment of the battery pack 100 of this application is proposed. In this embodiment, the battery pack 100 may further include a third collection module 910.

The third collection module 910 may be connected to the data processing module 130, and the third collection module 910 may be configured to collect electrical data of the cell 111. The electrical data includes at least one of a voltage value and current value of a loop in which the cell 111 is located, and an insulation resistance value of the cell 111.

The electrical data is also included in the third operational data, and whether the data detection condition of the electrical type is met can be determined based on at least one piece of the electrical data. The data detection condition of the electrical type may include that the insulation resistance value is less than a resistance threshold, the current value of the loop in which the cell 111 is located is greater than a current threshold, or a decrease speed of the voltage value of the loop in which the cell 111 is located is greater than a speed threshold. That is, if at least one of the insulation resistance value, the decrease speed of the voltage value, and the current value meets the condition, and the third operational data meets the data detection condition of the electrical type.

It should be noted that when the above data detection condition of the electrical type is met, it indicates that the loop in which the cell 111 is located may have a short circuit or severe self-discharge, which can easily cause thermal runaway risk. It is necessary to further determine whether the first temperature data meets the temperature runaway condition, so as to determine whether the cell 111 is in a short-circuit abnormality or if there is a thermal runaway risk caused by the loop short circuit.

In these embodiments, the thermal runaway risk caused by electrical reasons of the cell 111 is considered, exploring the root cause of internal thermal runaway of the cell 111, and providing a reference for subsequent thermal runaway analysis and detection.

Still referring to FIG. 9, based on the above embodiments, yet another embodiment of the battery pack 100 of this application is proposed. In this embodiment, the data processing module 130 may further be configured to: when it is determined, based on the electrical data, that the third operational data meets the data detection condition of a corresponding type and the first temperature data does not meet the temperature runaway condition, indicate the first detection result as the cell 111 having a short-circuit abnormality.

In this embodiment, after the electrical data is determined, determining whether the first temperature data meets the temperature runaway condition can determine whether the short-circuit abnormality of the cell 111 leads to the thermal runaway risk of the cell 111, achieving accurate short-circuit abnormality analysis of the cell 111.

In these embodiments, the electrical data, gas generation, and the internal pressure of the cell 111 form a level-1 signal collection system, thereby triggering the determining of whether the first temperature data meets the temperature runaway condition. This is based on various root causes of thermal runaway, comprehensively identifying inducements of thermal runaway while achieving thermal runaway risk warning.

Based on the above embodiments, yet another embodiment of the battery pack 100 of this application is proposed. In this embodiment, the second collection module 140 may include a second temperature collection unit 141. The second temperature collection unit 141 may be configured to be activated when the first detection result indicates that any one of the cell 111 has a thermal runaway risk, and collect second temperature data of the cell 111 after activation, where the second operational data may include the second temperature data.

The data processing module 130 may be further configured to: when the second temperature data is greater than an external temperature threshold, indicate the second detection result as the cell 111 having a level-2 thermal runaway risk.

Thus, when determining, based on the first operational data, that the cell 111 has a thermal runaway risk, the data processing module 130 can trigger the second temperature collection unit 141 to start and obtain the second temperature data from the second temperature collection unit 141. When the second temperature data is greater than the external temperature threshold, it indicates that there is also a temperature abnormality outside the cell module 110 within the battery pack 100. In this case, the cell 111 has a level-2 thermal runaway risk.

The second temperature collection unit 141 may be distributed around the cell module 110, or may be distributed around other components of the battery pack 100 besides the cell module 110. The second temperature collection unit 141 can respectively detect the temperature of the module and the temperature inside the battery pack 100. When any temperature exceeds the temperature warning value, it indicates that the cell 111 has a level-2 thermal runaway risk. The data processing module 130 can then issue a level-2 thermal runaway warning signal, thereby raising the thermal runaway risk level. Conversely, when all the temperatures collected by the second temperature collection unit 141 do not exceed the temperature warning value, it indicates that the cell 111 still has a thermal runaway risk. In this case, but no spillover risk has occurred.

With this solution, a risk signal indicating spread-out of internal thermal runaway of the cell 111 can be captured, so that the extent of the spread-out of internal thermal runaway of the cell 111 can be learned in time. Second, an external signal change caused by a change in external condition such as high temperature can be reflected, implementing thermal runaway risk warning caused by external factors.

In this embodiment, disposing the second temperature collection unit 141 provides an optional implementation manner for the data processing module 130 to perform secondary detection of thermal runaway risk based on the second operational data. In addition, the second temperature collection unit 141 is activated only when the first detection result indicates that any one of the cell 111 has a thermal runaway risk, and therefore the non-continuous working state of the second temperature collection unit 141 can avoid vain work, greatly improving the actual service life of the second temperature collection unit 141.

Referring to FIG. 9, based on the above embodiments, yet another embodiment of the battery pack 100 of this application is proposed. In this embodiment, in addition to the second temperature collection unit 141, the second collection module 140 may further include an external gas pressure and gas collection unit 142.

The external gas pressure and gas collection unit 142 may be configured to be activated when the first detection result indicates that any one of the cell 111 has a thermal runaway risk, and collect external gas pressure data and concentration of at least one type of external gas of the cell module 110 after activation.

The data processing module 130 may be further configured to: when the external gas pressure data is greater than an external gas pressure threshold, the concentration of at least one type of external gas is greater than a concentration threshold of a corresponding type, and the second temperature data is less than or equal to the external temperature threshold, indicate the second detection result as a level-2 gas generation abnormality warning.

For the specific type and abnormality determining logic of the external gas pressure and gas collection unit 142 of the external gas pressure and gas collection unit 142, reference may be made to the internal gas pressure and gas collection unit 810 inside the cell 111. Details are not described herein again.

When an external gas generation abnormality is detected by the external gas pressure and gas collection unit 142, the data processing module 130 can obtain the second temperature data collected by the second temperature collection unit 141. When the second temperature data is greater than the corresponding temperature threshold, a level-2 gas generation thermal runaway alarm can be issued, raising the thermal runaway risk level. Conversely, a level-2 gas generation abnormality alarm can be issued, raising the gas generation abnormality risk level.

It should be noted that when the external gas pressure and gas collection unit 142 detects an external gas generation abnormality, it indicates that the gas generation abnormality has caused the gas to burst through the explosion-proof valve of the cell module 110 and spill out to the outside of the cell 111, which is quite dangerous. With risk level prompts in different situations, the abnormality cause and danger level of the battery pack 100 can be learned in time, and measures can be correspondingly taken. In addition, disposing both the internal and external gas and gas pressure collection units and the temperature collection units, the accuracy of identifying thermal runaway and gas generation abnormality of the battery pack 100 can be improved, preventing erroneous determining.

Still referring to FIG. 9, based on the above embodiments, yet another embodiment of the battery pack 100 of this application is proposed. In this embodiment, the second collection module 140 may include a smoke concentration collection unit 143.

The smoke concentration collection unit 143 may be configured to be activated when the first detection result indicates that any one of the cell 111 has a thermal runaway risk, and collect smoke concentration outside the cell module 110 after activation, where the second operational data includes the smoke concentration; When the smoke concentration is greater than a smoke concentration warning value, the second detection result indicates that the cell 111 has a level-2 thermal runaway risk.

The smoke concentration collection unit 143 may be distributed around the cell module 110 and other locations of the battery pack 100 besides the cell module 110. It can respectively detect the smoke concentration of the module and the battery pack 100, and then compare their respective smoke concentrations with their respective smoke concentration warning values. When any smoke concentration exceeds the corresponding smoke concentration warning value, it indicates that the cell 111 has a level-2 thermal runaway risk. The data processing module 130 can issue a level-2 thermal runaway smoke warning signal for the cell 111, raising the thermal runaway risk level, and informing people around of the risk of smoke inhalation. Conversely, when all the smoke concentrations collected by the smoke concentration collection unit 143 do not exceed the smoke concentration warning value, it indicates that the cell 111 still has a thermal runaway risk. In this case, but no spillover risk has occurred yet.

With this solution, a risk signal indicating spread-out of internal thermal runaway of the cell 111 can be captured, so that the extent of the spread-out of internal thermal runaway of the cell 111 can be learned in time. Second, an external signal change caused by a change in external condition such as high temperature or high pressure can be reflected, implementing thermal runaway risk warning caused by external factors. It can also detect the phenomenon of smoke generation by the battery pack 100, reminding people around to take timely action.

In this embodiment, disposing the smoke concentration collection unit 143 provides an optional implementation manner for the data processing module 130 to perform secondary detection of thermal runaway risk based on the second operational data. The smoke concentration collection unit 143 can be combined with the second temperature collection unit 141, so that the presence of a level-2 thermal runaway risk of the cell 111 can be determined based on the data collected by either unit, improving the accuracy of external thermal runaway risk detection. In addition, the smoke concentration collection unit 143 is activated only when the first detection result indicates that any one of the cell 111 has a thermal runaway risk, and therefore the non-continuous working state of the smoke concentration collection unit 143 can avoid vain work, greatly improving the actual service life of the smoke concentration collection unit 143.

The battery pack of the embodiment of this application is described in detail above with reference to FIGs. 1 to 9. On this basis, an embodiment of this application further provides an electric apparatus. The electric apparatus includes the battery pack provided in the above embodiments. Therefore, the electric apparatus has all the beneficial effects of the battery pack.

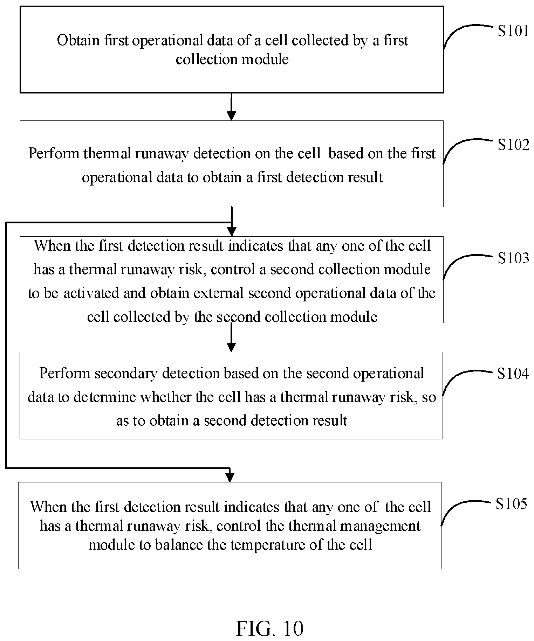

Referring to FIG. 10, based on the battery pack of the above embodiments, an embodiment of this application further provides a detection method of a battery pack. The method is applied to a data processing module. The battery pack may include a cell module, a first collection module, and a second collection module disposed outside the cell module, the cell module may include at least one cell, the first collection module may include at least one first collection unit, the first collection unit is disposed within the cell, and the method may include the following steps.

S101. Obtain first operational data of the cell collected by the first collection module.

S102. Perform thermal runaway detection on the cell based on the first operational data to obtain a first detection result.

S 103. When the first detection result indicates that any one of the cell has a thermal runaway risk, control the second collection module to be activated and obtain external second operational data of the cell collected by the second collection module.

S104. Perform secondary detection based on the second operational data to determine whether the cell has a thermal runaway risk, so as to obtain a second detection result.

In this embodiment of this application, the first collection unit is disposed within the cell, achieving direct collection of internal operational data of the cell, and more accurately reflecting the internal operation condition of the cell. In addition, the second collection module outside the cell module is activated after presence of a thermal runaway risk is determined based on the internal operational data of the cell, and secondary detection is performed based on the second operational data collected by the second collection module, so that the accuracy of thermal runaway warning detection can be improved through secondary detection by using internal and external data. In addition, activation is initiated only when the first detection result indicates the presence of a thermal runaway risk and in an intermittent collection state, thus extending the service life of the second collection module.

Still referring to FIG. 10, based on the above embodiments, another embodiment of the detection method of a battery pack of this application is proposed. In this embodiment, after S102, the method further includes:

S 105. When the first detection result indicates that any one of the cell has a thermal runaway risk, control the thermal management module to balance the temperature of the cell.

In these embodiments, the thermal management module balances the temperature of the cell after a level-1 warning is generated (that is, after the first detection result indicates that any one of the cell has a thermal runaway risk), a temperature reduction operation can be performed on the cell in advance as compared with related arts, helping to reduce the thermal runaway risk of the cell and improve the safety of the cell.

Based on the above embodiments, another embodiment of the detection method of the battery pack of this application is proposed. In this embodiment, the first collection unit includes a first temperature collection unit and a primary collection unit.

The performing thermal runaway detection on the cell based on the first operational data to obtain a first detection result may include: obtaining third operational data collected by the primary collection unit and first temperature data collected by the first temperature collection unit, the first operational data includes the third operational data and the first temperature data; and performing thermal runaway detection on the cell based on the first temperature data when the third operational data meets the data detection condition of a corresponding type.

The third operational data can be set with reference to the foregoing content. In these embodiments, a level-1 signal collection system may be formed with reference to the electrical data, gas generation, the third operational data related to the internal pressure of the cell, and the like, thereby triggering the determining of whether the first temperature data meets the temperature runaway condition. This can comprehensively identify inducements of thermal runaway based on various root causes of thermal runaway, while thermal runaway risk warning is implemented.

In addition, with reference to the detection method of the battery pack in the above embodiments, an embodiment of this application can provide a computer storage medium for implementation. The computer storage medium stores a computer program instruction. When the computer program instruction is executed by a processor, any one of the detection methods of the battery pack in the above embodiments is implemented.

In addition, an embodiment of this application further provides a computer program product, including a computer program. When the computer program is executed by a processor, the steps and corresponding contents of the foregoing method embodiments can be implemented.

Although this application has been described with reference to the preferred embodiments, various modifications to this application and replacements of the components therein with equivalents can be made without departing from the scope of this application. In particular, as long as there is no structural conflict, the various technical features mentioned in the embodiments can be combined in any manners. This application is not limited to the specific embodiments disclosed in this specification, but includes all technical solutions falling within the scope of the claims.

## Claims

1. A battery pack, comprising:
a cell module, comprising at least one cell;
a first collection module, comprising at least one first collection unit, wherein the first collection unit is disposed within the cell, and the first collection unit is configured to collect first operational data of the cell;
a data processing module, connected to the first collection unit, and configured to perform thermal runaway detection on the cell based on the first operational data to obtain a first detection result; and
a second collection module, disposed outside the cell module, and configured to be activated when the first detection result indicates that any one of the cell has a thermal runaway risk, and collect second operational data of the cell after activation; wherein
the data processing module is further connected to the second collection module, and further configured to perform secondary detection based on the second operational data to determine whether the cell has a thermal runaway risk, so as to obtain a second detection result.

2. The battery pack according to claim 1, wherein the battery pack further comprises:
a thermal management module, connected to the data processing module, and configured to balance temperature of the cell when the first detection result indicates that any one of the cell has a thermal runaway risk.

3. The battery pack according to claim 1, wherein the first collection unit comprises a first temperature collection unit, wherein
the first temperature collection unit is configured to collect first temperature data of the cell, the first operational data comprising the first temperature data; and
the data processing module is configured to perform thermal runaway detection on the cell based on the first temperature data, and when the first temperature data meets a temperature runaway condition, indicate the first detection result as the cell having a thermal runaway risk.

4. The battery pack according to claim 3, wherein the first collection unit further comprises a primary collection unit; wherein
the primary collection unit is configured to collect third operational data of the cell other than the first temperature data, the first operational data comprising the third operational data; and
the data processing module is configured to perform thermal runaway detection on the cell based on the first temperature data when the third operational data meets a data detection condition of a corresponding type.

5. The battery pack according to claim 4, wherein the cell comprises a housing and electrode plates accommodated in the housing, and the primary collection unit comprises:
a pressure collection unit, wherein the pressure collection unit corresponds to the first temperature collection unit, the pressure collection unit is attached to an inner surface of the housing and/or the electrode plates, and the pressure collection unit is configured to collect pressure data of the cell, the third operational data comprising the pressure data;
wherein when the pressure data is greater than a pressure threshold, the third operational data meets the data detection condition of a corresponding type.

6. The battery pack according to claim 5, wherein the data processing module is further configured to: when the pressure data is greater than the pressure threshold and the first temperature data does not meet the temperature runaway condition, indicate the first detection result as the cell having a force abnormality.

7. The battery pack according to claim 4, wherein the cell comprises a jelly roll, a housing, and a top cover, the jelly roll being accommodated in an accommodation space enclosed by the housing and the top cover, and the primary collection unit comprises:
an internal gas pressure and gas collection unit, disposed between the top cover and the jelly roll, and configured to collect gas pressure data inside the housing and concentration of at least one type of gas;
wherein when the gas pressure data is greater than a gas pressure threshold and gas concentration of any type is greater than a concentration threshold of a corresponding type, the third operational data meets the data detection condition of a corresponding type.

8. The battery pack according to claim 7, wherein the data processing module is further configured to: when the gas pressure data is greater than the gas pressure threshold, the first temperature data does not meet the temperature runaway condition, and the gas concentration of any type is greater than the concentration threshold of a corresponding type, indicate the first detection result as the cell having a gas generation abnormality.

9. The battery pack according to claim 4, wherein the battery pack further comprises:
a third collection module, configured to collect electrical data corresponding to the cell, the electrical data comprising at least one of a voltage value and current value of a loop in which the cell is located, and an insulation resistance value of the cell;
wherein when the insulation resistance value is less than a resistance threshold, the current value is greater than a current threshold, or a decrease speed of the voltage value is greater than a speed threshold, the third operational data meets the data detection condition of a corresponding type.

10. The battery pack according to claim 9, wherein the data processing module is further configured to: when it is determined, based on the electrical data, that the third operational data meets the data detection condition of a corresponding type and the first temperature data does not meet the temperature runaway condition, indicate the first detection result as the cell having a short-circuit abnormality.

11. The battery pack according to claim 1, wherein the second collection module comprises:
a second temperature collection unit, configured to be activated when the first detection result indicates that any one of the cell has a thermal runaway risk, and collect second temperature data of the cell after activation, the second operational data comprising the second temperature data; wherein
the data processing module is further configured to: when the second temperature data is greater than an external temperature threshold, indicate the second detection result as the cell having a level-2 thermal runaway risk.

12. The battery pack according to claim 11, wherein the second collection module further comprises:
an external gas pressure and gas collection unit, configured to be activated when the first detection result indicates that any one of the cell has a thermal runaway risk, and collect external gas pressure data and concentration of at least one type of external gas of the cell module after activation; wherein
the data processing module is further configured to: when the external gas pressure data is greater than an external gas pressure threshold, the concentration of at least one type of external gas is greater than a concentration threshold of a corresponding type, and the second temperature data is less than or equal to the external temperature threshold, indicate the second detection result as a level-2 gas generation abnormality warning.

13. The battery pack according to claim 1, wherein the second collection module comprises:
a smoke concentration collection unit, configured to be activated when the first detection result indicates that any one of the cell has a thermal runaway risk, and collect smoke concentration outside the cell module after activation, the second operational data comprising the smoke concentration;
wherein when the smoke concentration is greater than a smoke concentration warning value, the second detection result indicates that the cell has a level-2 thermal runaway risk.

14. An electric apparatus, wherein the electric apparatus comprises the battery pack according to any one of claims 1 to 13.

15. A detection method of a battery pack, applied to a data processing module, wherein the battery pack comprises a cell module, a first collection module, and a second collection module disposed outside the cell module, the cell module comprising at least one cell, the first collection module comprising at least one first collection unit, and the first collection unit being disposed within the cell, and the method comprises:
obtaining first operational data of the cell collected by the first collection module;
performing thermal runaway detection on the cell based on the first operational data to obtain a first detection result;
when the first detection result indicates that any one of the cell has a thermal runaway risk, controlling the second collection module to be activated and obtaining external second operational data of the cell collected by the second collection module; and
performing secondary detection based on the second operational data to determine whether the cell has a thermal runaway risk, so as to obtain a second detection result.

16. A computer storage medium, wherein when executed by a processor, the computer storage medium performs the detection method of the battery pack according to claim 15.
